# EUROPÄISCHE PATENTSCHRIFT

(11) **EP 3 224 955 B1**
(45) Veröffentlichungstag und Bekanntmachung des Hinweises auf die Patenterteilung: **26.02.2020**
(21) Anmeldenummer: 15804703.5
(22) Anmeldetag: 25.11.2015
(51) Int. Cl.: H03K 17/945

(54) **SCHALTERBETÄTIGUNGSEINRICHTUNG, MOBILES GERÄT UND VERFAHREN ZUM BETÄTIGEN EINES SCHALTERS DURCH EINE NICHT-TAKTILE GESTE**
SWITCH ACTUATING DEVICE, MOBILE DEVICE, AND METHOD FOR ACTUATING A SWITCH BY MEANS OF A NON-TACTILE GESTURE
DISPOSITIF DE COMMANDE DE COMMUTATEUR, APPAREIL MOBILE ET PROCÉDÉ DE COMMANDE D'UN COMMUTATEUR PAR UN GESTE NON TACTILE

(30) Priorität: 27.11.2014 DE 102014017585
(43) Veröffentlichungstag der Anmeldung: 04.10.2017
(73) Patentinhaber: Pyreos Ltd., Edinburgh EH9 3JF (GB)
(72) Erfinder: BROWN, Spyros, Edinburgh EH11 2LJ (GB); CHAMBERLAIN, Tim, Edinburgh EH14 1HE (GB); HURWITZ, Jonathan Ephraim David, Edinburgh EH6 7PJ (GB); GIEBELER, Carsten, Edinburgh EH32 0PE (GB)
(74) Vertreter: Mewburn Ellis LLP
(86) Internationale Anmeldenummer: PCT/EP2015/077666
(87) Internationale Veröffentlichungsnummer: WO 2016/083462

(56) Entgegenhaltungen:
- DE-A1-102013 200 457
- DE-U1- 8 705 296
- JP-A- 2008 232 715
- US-A1- 2010 295 773
- HENG-TZE CHENG ET AL: "Contactless gesture recognition system using proximity sensors", CONSUMER ELECTRONICS (ICCE), 2011 IEEE INTERNATIONAL CONFERENCE ON, IEEE, 9. Januar 2011 (2011-01-09), Seiten 149-150, XP031921157, DOI: 10.1109/ICCE.2011.5722510 ISBN: 978-1-4244-8711-0
- WOJTCZUK P ET AL: "Recognition of Simple Gestures Using a PIR Sensor Array", SENSORS & TRANSDUCERS, INTERNATIONAL FREQUENCY SENSOR ASSOCIATION, CA, Bd. 14, Nr. 1, 12. März 2012 (2012-03-12), Seiten 83-94, XP002714652, ISSN: 1726-5479

## Beschreibung

Die Erfindung betrifft eine Schalterbetätigungseinrichtung, ein mobiles Gerät mit der Schalterbetätigungseinrichtung und ein Verfahren zur Betreiben eines Schalters mit der Schalterbetätigungseinrichtung durch eine nicht-taktile Geste, insbesondere von einer menschlichen Hand.

Zur Mensch-Computer-Interaktion sind interaktive Systeme und deren Mensch-Maschine-Schnittstellen bekannt, die mit einer Einrichtung zur automatischen Erkennung von durch Menschen ausgeführten nicht-taktilen oder taktilen Gesten ausgestattet sind. Die Geste kann prinzipiell von jeder Körperhaltung und jeder Körperbewegung abgeleitet werden, wobei die größte Bedeutung Handgesten haben. Die Gestenerkennungseinrichtung ist mit einem Gerät zur optischen Erfassung insbesondere der gestikulierenden Hand ausgestattet, wobei die dadurch erzeugten Bildinformationen mit entsprechenden Algorithmen ausgewertet werden, um eine Geste aus den Bildinformationen abzuleiten. Das Gerät zur optischen Erfassung einer nicht-taktilen Geste ist herkömmlich eine Kamera, die nachteilig einen großen Bauraum einnimmt und hohe Investitionskosten mit sich bringt. Dadurch sind kamerabasierte Einrichtungen zur Gestenerkennung in miniaturisierter Bauweise bei günstigen Kosten, wie es etwa für die Anwendung in Mobiltelefonen vorteilhaft wäre, nicht zu realisieren. Außerdem haben kamerabasierte Einrichtungen nachteilig einen hohen Energieverbrauch, wodurch mobile Anwendungen nur schwer umzusetzen sind. Alternativ sind Hochgeschwindigkeitsspektrometer bekannt, die hinsichtlich der miniaturisierten Bauweise bei geringen Kosten keine Abhilfe schaffen können. Außerdem sind Berührungsbildschirme für insbesondere Mobiltelefone bekannt, jedoch sind die Berührungsbildschirme nur für die Erkennung von taktilen Gesten und nicht für die Erkennung von nicht-taktilen Gesten geeignet.

Die US2010/0295773 zeigt einen Gestendetektor mit vier Sensoren zur Erfassung von reflektierter Infrarotstrahlung.

Aufgabe der Erfindung ist es eine Schalterbetätigungseinrichtung, ein mobiles Gerät mit der Schalterbetätigungseinrichtung und ein Verfahren zum Betreiben eines Schalters mit der Schalterbetätigungseinrichtung durch eine nicht-taktile Geste zu schaffen, wobei die Schalterbetätigungseinrichtung eine miniaturisierte Bauweise bei günstigen Kosten und geringem Energieverbrauch hat und die Betätigung des Schalters mit der Schalterbetätigungseinrichtung sicher und fehlerarm ist.

Die Aufgabe wird gelöst mit den Merkmalen der Patentansprüche 1, 6 und 7. Bevorzugte Ausgestaltungen dazu sind in den weiteren Patentansprüchen angegeben.

Die erfindungsgemäße Schalterbetätigungseinrichtung zum Betätigen eines Schalters durch acht mögliche Arten von nicht-taktilen Gesten, die mit einem Wärme emittierenden Teil auszuüben sind, weist einen Gestensensor, der eingerichtet ist beim Ausüben einer der Arten der Gesten vom Teil emittierte Wärme mittels vier Pixel zu detektieren und pro Pixel, die jeweils einen Dünnfilm aus pyroelektrischem Material aufweisen, ein Signal mit einem Signalausschlag entsprechend dem zeitlichen Intensitätsverlauf der vom Dünnfilm des entsprechenden Pixels detektierten Wärme auszugeben, eine Signalauswerteeinheit, mit der aus dem zeitlichen Aufeinanderfolgen der Signalausschläge die Ausübung einer der Arten der Gesten ermittelbar ist, und einen Aktuator auf, der von der Signalauswerteeinheit angesteuert ist und, sobald die Ausübung einer der Arten der Gesten ermittelt ist, den Schalter betätigt, wobei die Arten der Geste von einer Annäherungsphase, bei der das Teil sich dem Gestensensor annähert, einer darauffolgenden Wartephase, bei der das Teil in der Nähe des Gestensensors verharrt, und einer darauffolgenden Translationsphase, bei der das Teil in eine von acht Richtungen sich bewegt, gebildet ist, wobei die vier einen Richtungen eine Längsrichtung, eine der Längsrichtung entgegen gerichtete Richtung, eine Querrichtung, die im rechten Winkel zu der Längsrichtung ist, eine der Querrichtung entgegen gerichtete Richtung sind und die vier anderen Richtungen jeweils um 45° zu einer der ihr entsprechenden vier einen Richtungen gedreht sind, wobei die vier Pixel jeweils in einer der Ecken eines konvexen Vierecks angeordnet sind, dessen eine der Diagonalen im Wesentlichen parallel zur Längsrichtung und die andere Diagonale im Wesentlichen parallel zur Querrichtung sind.

Das erfindungsgemäße mobile Gerät weist die Schalterbetätigungseinrichtung auf, wobei der Schalter zum Aktivieren / Deaktivieren einer Funktionalität des mobilen Gerätes in diesem verschaltet ist.

Das erfindungsgemäße Verfahren zum Betreiben einer Schalterbetätigungseinrichtung weist die Schritt auf: Ausgeben von den Pixeln der Signalausschläge hervorgerufen in der Annäherungsphase und der Signalausschläge hervorgerufen in der Translationsphase an die Signalauswerteeinheit, indem die nicht-taktile Geste mit dem Wärme emittierenden Teil ausgeübt wird, wobei zwischen den Signalausschlägen während der Wartephase vom Signal ein Warteniveau erreicht wird, das einen geringeren Betrag hat als die Beträge der Extremwerte der Signalausschläge; Überwachen des Signals und Identifizieren des Auftretens einer Aufeinanderfolge der Signalausschläge und dem zeitlich dazwischen liegenden Warteniveau des Signals; Sobald die Aufeinanderfolge identifiziert wurde, Fortfahren mit dem nächsten Schritt; Überprüfen, ob die Signalausschläge hervorgerufen in der Annäherungsphase eine entgegengesetzte Richtung haben wie die Signalausschläge hervorgerufen in der Translationsphase; Ist die Überprüfung positiv, Fortfahren mit den nächsten Schritt; Überprüfen, ob der Zeitversatz der Signalausschläge hervorgerufen in der Annäherungsphase innerhalb einer ersten vorherbestimmten Zeitspanne liegt; Ist die Überprüfung positiv, Fortfahren mit dem nächsten Schritt; Überprüfen, ob der Zeitversatz des zeitlich ersten und des zeitlich letzten Signalausschlags hervorgerufen in der Translationsphase innerhalb zweier Schwellenwerte liegt, deren unterer Schwellenwert größer als Null ist; Ist die Überprüfung positiv, Fortfahren mit dem nächsten Schritt; Identifizieren einer der acht Arten der Gesten anhand der zeitlichen Abfolge der Signalausschläge hervorgerufen in der Translationsphase; Je nach identifizierter Art der Geste: Entsprechendes Ansteuern des Aktuators zum Betätigen des Schalters durch die Signalauswerteeinheit.

Dadurch, dass die Pixel jeweils den Dünnfilm aus dem pyroelektrischen Material, bevorzugt Bleizirkonattitanat, aufweisen, sind die Signale, die vom Wärme emittierenden Teil beim Ausüben von den nicht-taktilen Gesten erzeugt werden, derart vorteilhaft beschaffen, dass die Erkennung der Art der ausgeübten Geste mit dem erfindungsgemäßen Verfahren sicher und fehlerarm durchführbar ist. Außerdem ist der Gestensensor mit den Pixeln derart in einer miniaturisierten Bauweise bei günstigen Kosten herstellbar, dass die Schalterbetätigungseinrichtung für das mobile Gerät vorteilhaft einsetzbar ist. Das Signal wird mit den Dünnfilmen durch die von dem Teil emittierte Wärme erzeugt, so dass der Gestensensor mit einer externen Energiequelle nicht mit Energie versorgt zu werden braucht. Somit weist die Schalterbetätigungseinrichtung die Signalauswerteeinheit und den Aktuator als Energieverbraucher auf, so dass insgesamt der Energieverbrauch der Schalterbetätigungseinrichtung für das mobile Gerät vorteilhaft niedrig ist.

Beispielsweise kann die erste Art der Geste das Ausführen eines ENTER-Befehls bewirken und die zweite Art der Geste das Ausführen eines ESCAPE-Befehls bewirken.

Bevorzugtermaßen ist das Viereck ein Rhombus. Der Abstand von zwei unmittelbar benachbarten Pixeln beträgt bevorzugt zwischen 50 µm bis 300 µm. Außerdem ist es bevorzugt, dass das Teil eine menschliche Hand und die vom Teil emittierte Wärme die von der menschlichen Hand abgestrahlte Körperwärme ist. Mit den bevorzugten Ausgestaltungen der Schalterbetätigungseinrichtung ist die Erkennung der Art der ausgeübten nicht-taktilen Geste mit der menschlichen Hand im Rahmen üblicher menschlicher Bewegungsabläufe besonders sicher und fehlerarm ermöglicht.

Es ist bevorzugt, dass die erste vorherbestimmte Zeitspanne maximal 40 ms lang ist. Damit ist vorteilhaft der Grad der Gleichzeitigkeit des Auftretens der in der Annäherungsphase hervorgerufenen Signalausschläge für die sichere und fehlerfreie Gestenerkennung festgelegt. Der untere Schwellenwert liegt bevorzugt bei 10 ms und der obere Schwellenwert bei 100 ms. Dadurch wird vorteilhaft der zeitliche Nachlauf des letzten in der Translationsphase hervorgerufenen Signalausschlags zu dem ersten in der Translationsphase hervorgerufenen Signalausschlag für eine sichere und fehlerfreie Gestenerkennung festgelegt.

Das Verfahren weist bevorzugt den Schritt auf: Überprüfen, ob der zeitliche Versatz derjenigen Signalausschläge hervorgerufen in der Translationsphase, die zeitlich zwischen dem ersten und dem zeitlich letzten Signalausschlag hervorgerufen in der Translationsphase innerhalb einer zweiten vorherbestimmten Zeitspanne,insbesondere ist die zweite vorherbestimmte Zeitspanne 0,5 ms, liegt, wodurch die Richtung der ausgeübten Geste während der Translationsphase als eine der vier einen Richtungen identifizierbar wird; Ist die Überprüfung positiv, Fortfahren mit dem nächsten Schritt. Alternativ bevorzugt weist das Verfahren den Schritt auf: Überprüfen, ob der zeitliche Versatz der zeitlich ersten beiden Signalausschläge und der letzten beiden Signalausschläge hervorgerufen in der Translationsphase innerhalb einer zweiten vorherbestimmten Zeitspanne, insbesondere ist die zweite vorherbestimmte Zeitspanne 0,5 ms, liegt, wodurch die Richtung der ausgeübten Geste während der Translationsphase als eine der vier anderen Richtungen identifizierbar wird; Ist die Überprüfung positiv, Fortfahren mit dem nächsten Schritt.

Es ist bevorzugt, dass das Verfahren den Schritt aufweist: Überprüfen, ob die Dauer der Wartephase innerhalb zweier Warteschwellenwerte liegt, wobei deren unterer Warteschwellenwert größer als Null ist; Ist die Überprüfung positiv, Fortfahren mit dem nächsten Schritt. Es ist bevorzugt, dass der untere Warteschwellenwert bei 100 ms und der obere Warteschwellenwert bei 1500 ms liegt. Damit ist vorteilhaft die Dauer der Wartephase für eine sichere und fehlerfreie Gestenerkennung festgelegt.

Es ist bevorzugt, dass das Verfahren den Schritt aufweist: Überprüfen, ob der Betrag der ersten Ableitung nach der Zeit des steilsten Wendepunkts der Signalausschläge hervorgerufen in der Translationsphase größer als der Betrag der ersten Ableitung nach der Zeit des steilsten Wendepunkts der Signalausschläge hervorgerufen in der Annäherungsphase ist; Ist dies der Fall, Fortfahren mit dem nächsten Schritt. Dadurch kann vorteilhaft auf eine besonders sichere und fehlerfreie Weise zwischen der Annäherungsphase und der Translationsphase unterschieden werden.

Bevorzugt weist das Verfahren den Schritt auf: Überprüfen, ob die Beträge der Extremwerte der Signalausschläge größer als ein vorherbestimmter Grenzwert sind; Ist dies der Fall, Fortfahren mit dem nächsten Schritt. Dadurch wird vorteilhaft erreicht, dass Störsignale, die etwa durch Einflüsse aus der Umgebung von den Pixeln abgegeben werden, die Gestenauswertung nicht beeinträchtigen, wodurch die Genauigkeit der Gestenerkennung erhöht ist.

Das Verfahren weist bevorzugt den Schritt auf: Überprüfen, ob der Betrag des Warteniveaus höchstens bei 20% mindestens eins der Beträge der Extremwerte ist; Ist dies der Fall, Fortfahren mit dem nächsten Schritt. Bevorzugt weist das Verfahren den Schritt auf: Überprüfen, ob das Warteniveau im Wesentlichen bei Null liegt.

Im Folgenden wird eine bevorzugte Ausführungsform der Erfindung anhand der beigefügten schematischen Zeichnungen erläutert. Es zeigen:
Figur 1 eine schematische Darstellung einer erfindungsgemäßen Schalterbetätigungseinrichtung für ein erfindungsgemäßes mobiles Gerät mit der zweiten Art von Geste,
Figur 2 eine schematische Darstellung mit den acht Arten von Gesten,
Figur 3 eine schematische Darstellung eines Gestensensors,
Figur 4 eine Auftragung mit Signalverläufen des Gestensensors aus Figur 3 für die erste Art von Geste,
Figur 5 eine Detailansicht von Figur 4,
Figur 6 eine Auftragung mit Signalverläufen des Gestensensors aus Figur 3 für die fünfte Art von Geste und
Figur 7 eine Detailansicht von Figur 6.

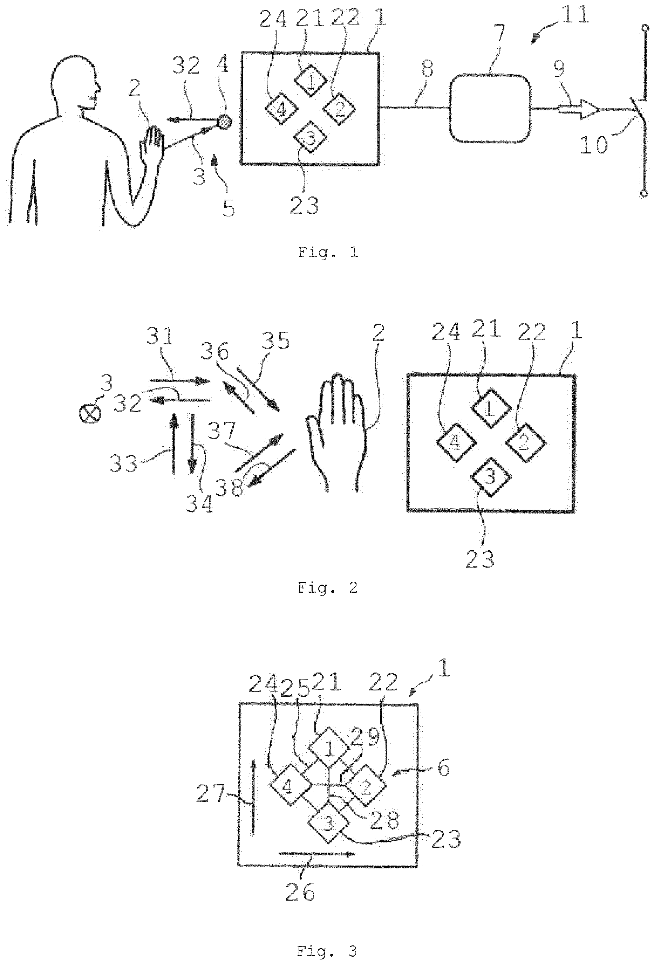

In Figur 1 ist eine Schalterbetätigungseinrichtung 11 gezeigt, die in ein mobiles Gerät eingebaut ist. Die Schalterbetätigungseinrichtung 11 weist einen Gestensensor 1 und eine Signalauswerteeinheit 7 auf, die via eine Signalleitung 8 zum Übertragen von Signalen vom Gestensensor 1 zur Signalauswerteeinheit 7 gekoppelt ist. Entsprechend der Auswertung der Signale, die vom Gestensensor 1 auf die Signalauswerteeinheit 7 übertragen werden, aktiviert oder deaktiviert die Signalauswerteeinheit 7 einen Aktuator 9, mit dem ein Schalter 10 des mobilen Geräts betätigbar ist. Der Schalter 10 ist zum Aktivieren / Deaktivieren einer Funktionalität des mobilen Geräts in diesem verschaltet.

Der Gestensensor 1 ist zum Detektieren von nicht-taktilen Gesten vorgesehen, wobei, je nachdem welche Geste der Gestensensor 1 detektiert, ein Signal oder mehrere Signale via die Signalleitung 8 zur Signalauswerteeinheit 7 übertragen werden, aufgrund dessen die Betätigung des Schalters 10 via den Aktuator 9 bewerkstelligt ist. Die Betätigung des Schalters 10 wird nur dann ausgelöst, wenn vom Gestensensor 1 und von der Signalauswerteeinheit 7 eine von den acht Arten von Gesten 3, 4, 31 bis 38 identifiziert ist. Die Gesten sind mit einer Hand 2 in der Nähe des Gestensensors 1 nicht-taktil auszuüben, wobei vom Gestensensor 1 von der Hand 2 emittierte Wärme detektierbar ist.

Die acht Arten von Gesten 3, 4, 31 bis 38 sind gebildet von einer Annäherungsphase 3, bei der die Hand 2 sich dem Gestensensor 1 annähert, einer auf die Annäherungsphase 3 folgende Wartephase 4, bei der die Hand 2 in der Nähe des Gestensensors 1 verharrt, und einer auf die Wartephase 4 folgende Translationsphase, bei der die Hand 2 in eine von acht Richtungen sich bewegt. Die acht Arten von Gesten 3, 4, 31 bis 38 sind für die Annäherungsphase 3 und die Wartephase 4 identisch und unterscheiden sich hinsichtlich der Richtung, in welcher die Hand 2 sich in der Translationsphase bewegt. In Figur 1 ist die zweite Art von Geste 3, 4, 32 dargestellt. In Figur 1 gesehen ist die zweite Art von Geste 3, 4, 32 in der Translationsphase eine Bewegung der Hand 2 von rechts nach links.

Figur 2 zeigt alle acht Arten der Geste 3, 4, 31 bis 38. In Figur 1 gesehen ist die erste Art von Geste 3, 4, 31 in der Translationsphase eine Bewegung der Hand 2 von links nach rechts, die zweite Art von Geste 3, 4, 32 in der Translationsphase eine Bewegung der Hand 2 von rechts nach links. Die dritte Art von Geste 3, 4, 33 ist in der Translationsphase eine Bewegung der Hand 2 von unten nach oben, wobei die vierte Art von Geste 3, 4, 34 in der Translationsphase eine Bewegung der Hand 2 von oben nach unten ist. Ferner ist die fünfte Art von Geste 3, 4, 35 in der Translationsphase eine Bewegung der Hand 2 von links oben nach rechts unten und die sechste Art von Geste 3, 4, 36 ist in der Translationsphase eine Bewegung der Hand 2 von rechts unten nach links oben. Außerdem ist die siebte Art von Geste 3, 4, 37 in der Translationsphase eine Bewegung der Hand von links unten nach rechts oben und die achte Art von Geste 3, 4, 38 ist in der Translationsphase eine Bewegung der Hand von rechts oben nach links unten. Es ist beispielhaft denkbar, dass mittels der ersten Art von Geste 3, 4, 31 die Schalterbetätigungseinrichtung 11 einen ENTER-Befehl und mittels der zweiten Art von Geste 3, 4, 32 die Schalterbetätigungseinrichtung 11 einen ESCAPE-Befehl ausführt.

In Figur 3 ist eine schematische Darstellung des Gestensensors 1 gezeigt, der ein Rhombus 6 mit einer Längsdiagonale 28 und einer Querdiagonale 29 aufweist, wobei in jeder Ecke des Rhombus 6 jeweils ein Pixel 21 bis 24 angeordnet ist. In Figur 3 gesehen ist in der oberen Ecke des Rhombus 6 das erste Pixel 21, in der rechten Ecke des Rhombus 6 das zweite Pixel 22, in der unteren Ecke des Rhombus 6 das dritte Pixel 23 und in der linken Ecke des Rhombus 6 das vierte Pixel 24 angeordnet. Der Abstand 25 von zwei unmittelbar benachbarten Pixeln liegt zwischen 50 µm bis 300 µm. Eine Längsrichtung 26, die in Figur 3 waagerecht verläuft, ist parallel zur Längsdiagonale 29, die vom vierten Pixel 24 und vom zweiten Pixel 22 gebildet ist. Eine Querrichtung 27 ist in Figur 3 gesehen parallel zur Querdiagonale 28, die vom ersten Pixel 21 und vom dritten Pixel 23 gebildet ist. Die Gesten erster Art 31 und zweiter Art 32 verlaufen in der Translationsphase parallel zur Längsrichtung 26, wohingegen die Gesten dritter Art 33 und vierter Art 34 in der Translationsphase parallel zur Querrichtung 27 verlaufen, wobei die Gesten der ersten Art 31 und der zweiten Art 32 gegensätzliche Richtungen in der Translationsphase und die Gesten der dritten Art 33 und der vierten Art 34 gegensätzliche Richtungen in der Translationsphase haben.

Die Pixel 21 bis 24 weisen jeweils einen Dünnfilm aus Bleizirkonattitanat auf, mit dem das Signal erzeugt wird, sobald das jeweilige Pixel 21 bis 24 eine zeitliche Änderung von der Hand 2 emittierten Wärme detektiert. Somit wird beim Ausüben einer der Gesten mit der Hand 2 von jedem Pixel 21 bis 24 das Signal mit einem Signalausschlag 48, 78 entsprechend dem zeitlichen Intensitätsverlauf der vom Dünnfilm des entsprechenden Pixels 21 bis 24 detektierten Wärme an die Signalauswerteeinheit 7 ausgegeben.

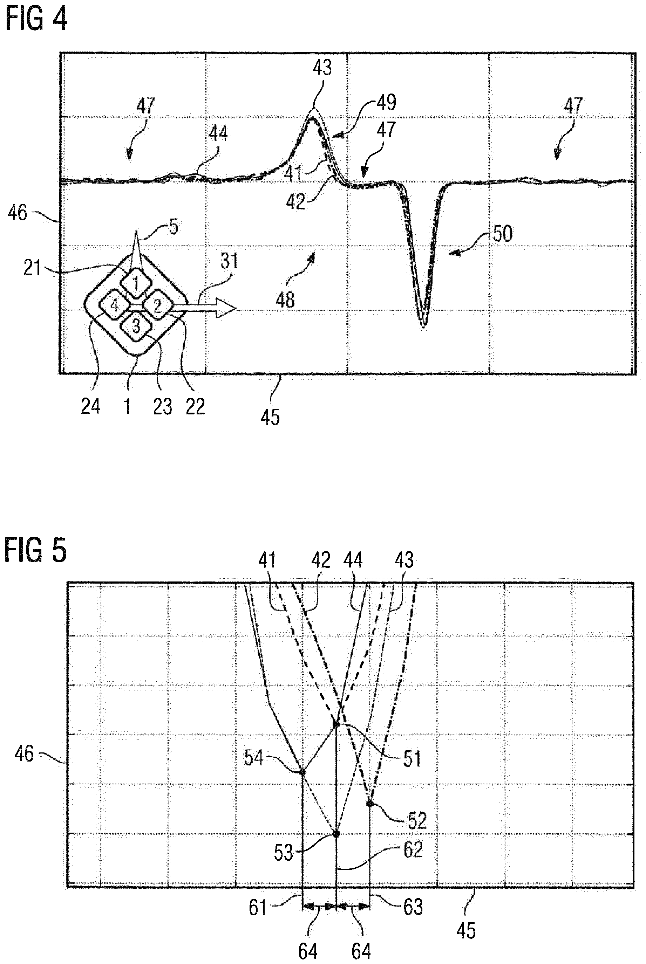

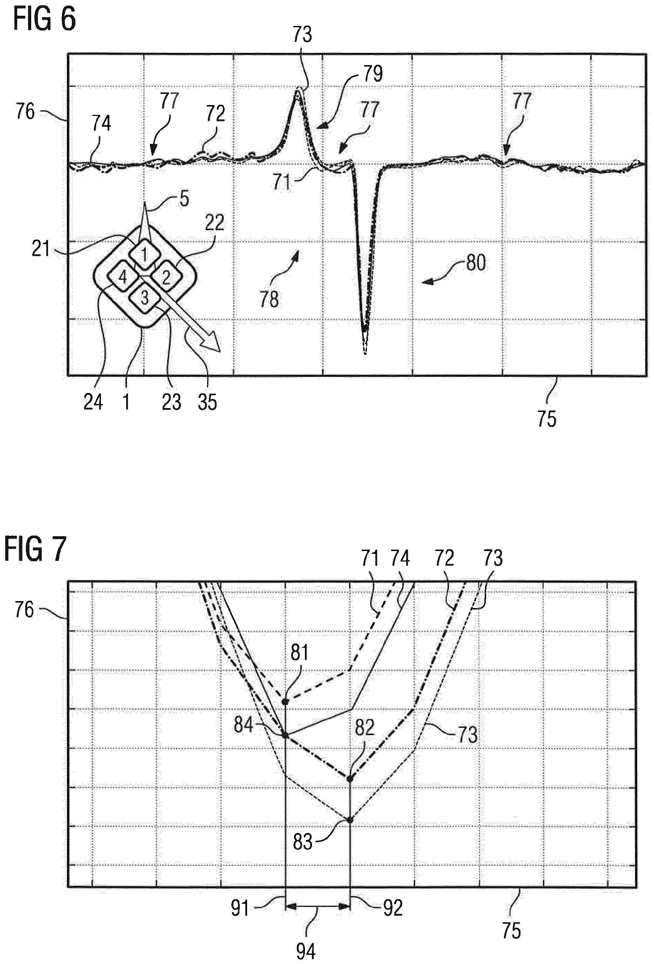

Figuren 4 und 5 zeigen die Signalausschläge 48 bei der ersten Art von Geste 3, 4, 31 und Figuren 6 und 7 zeigen die Signalausschläge 78 bei der fünften Art von Geste 3, 4, 35. In Figuren 4 und 5 ist das Signal des ersten Pixels 21 mit dem Bezugszeichen 41, das Signal des zweiten Pixels 22 mit dem Bezugszeichen 42, das Signal des dritten Pixels 23 mit dem Bezugszeichen 43 und das Signal des vierten Pixels 24 mit Bezugszeichen 44 bezeichnet. In Figuren 6 und 7 ist das Signal des ersten Pixels 21 mit dem Bezugszeichen 81, das Signal des zweiten Pixels 22 mit dem Bezugszeichen 82, das Signal des dritten Pixels 23 mit dem Bezugszeichen 83 und das Signal des vierten Pixels 24 mit Bezugszeichen 84 bezeichnet. In Figuren 4 und 5 ist eine Auftragung mit den zeitlichen Signalverläufen der von den Pixeln 21 bis 24 ausgegebenen Signalen 41 bis 44 gezeigt, wobei über der Abszisse 45 die Zeit und über die Ordinate 46 das Signal aufgetragen sind. In Figuren 6 und 7 ist eine Auftragung mit den zeitlichen Signalverläufen der von den Pixeln 21 bis 24 ausgegebenen Signalen 81 bis 84 gezeigt, wobei über der Abszisse 75 die Zeit und über die Ordinate 76 das Signal aufgetragen sind. Bei allen Auftragungen ist das Signal eine elektrische Spannung.

Wie es aus Figuren 4 und 6 ersichtlich ist, weisen die Signalausschläge 48, 78 jeweils einen in der Annäherungsphase hervorgerufenen Signalausschlag 49, 79 und jeweils einen in der Translationsphase hervorgerufenen Signalausschlag 50, 80 auf, der zeitlich nach dem in der Annäherungsphase hervorgerufenen Signalausschlag 49, 79 liegt. Dabei haben die in der Annäherungsphase hervorgerufenen Signalausschläge 49, 79 ein entgegen gesetztes Vorzeichen zu den in der Translationsphase hervorgerufenen Signalausschläge 50, 80. In Figuren 4 und 6 weisen die in der Annäherungsphase hervorgerufenen Signalausschläge 49, 79 ein Maximum und die in der Translationsphase hervorgerufenen Signalausschläge 50, 80 ein Minimum auf. Zwischen den in der Annäherungsphase hervorgerufenen Signalausschläge 49, 79 und den in der Translationsphase hervorgerufenen Signalausschläge 50, 80 ist jeweils ein Warteniveau 47, 77 angeordnet, das der Wartephase 4 entspricht.

Figur 5 zeigt eine Vergrößerung der in der Translationsphase hervorgerufenen Minima aus Figur 4 und Figur 7 zeigt eine Vergrößerung der in der Translationsphase hervorgerufenen Minima aus Figur 6. Jeder der Signalverläufe 41 bis 44 aus Figuren 4 und 5 weist ein jeweiliges Minimum 51 bis 54 und jedes der Signalverläufe 71 bis 74 weist ein jeweiliges Minimum 81 bis 84 auf. Figur 5 zeigt, dass bei der ersten Art von Geste 3, 4, 31 das Minimum 54 des Signalverlaufs 44 des vierten Pixels 24 bei einem ersten Zeitpunkt 61, die Minima 51, 53 der Signalverläufe 41, 43 des ersten Pixels 21 und des dritten Pixels 23 bei einem Zeitpunkt 62 und das Minimum 52 des Signalverlaufs 42 des zweiten Pixels 22 bei einem dritten Zeitpunkt 63 liegen. Der dritte Zeitpunkt 63 liegt zeitlich nach dem zweiten Zeitpunkt 62, der zeitlich nach dem ersten Zeitpunkt 61 liegt, wobei der Zeitversatz 64 von dem zweiten Zeitpunkt 62 zu dem ersten Zeitpunkt 61 und der Zeitversatz 64 von dem dritten Zeitpunkt 64 zu dem zweiten Zeitpunkt 62 identisch ist. Figur 7 zeigt, dass bei der fünften Art von Geste 3, 4, 35 die Minima 81, 84 der Signalverläufe 71, 74 des ersten Pixels 21 und des vierten Pixels 24 bei einem ersten Zeitpunkt 91 und die Minima 82, 83 der Signalverläufe 72, 73 des zweiten Pixels 22 und des dritten Pixels 23 bei einem zweiten Zeitpunkt 92 liegen, wobei der zweite Zeitpunkt 92 zeitlich nach dem ersten Zeitpunkt 91 liegt.

Ein Verfahren zum Identifizieren der ersten vier Arten von Gesten und zum Betreiben der Schalterbetätigungseinrichtung 11 weist die Schritte in Bezug auf Figuren 4 und 5 auf: Indem die nicht-taktile Geste mit der Hand 2 ausgeübt wird, werden von den Pixeln 21 bis 24 die Signalausschläge 48 ausgegeben. Die Signale 41 bis 44 werden untersucht nach dem Auftreten der Aufeinanderfolge der Signalausschläge 48 inklusive dem Warteniveau 47. Dann wird überprüft, ob die Signalausschläge 49 eine entgegengesetzte Richtung haben wie die Signalausschläge 50, und ob der Zeitversatz der Signalausschläge 49 innerhalb 50 ms liegt. Ferner wird überprüft, ob der Zeitversatz des zeitlich ersten 44 und des zeitlich letzten 42 Signalausschlags 50 zwischen 10 ms und 100 ms liegt. Liegt außerdem die Dauer der Wartephase 4 innerhalb 100 ms und 1500 ms und liegt der zeitliche Versatz der Signalausschläge 41, 43 innerhalb 0,5 ms, ist die Richtung der ausgeübten Geste während der Translationsphase als eine der vier einen Richtungen identifizierbar. Gemäß Figuren 4 und 5 weist die ausgeübte Geste die Richtung von links nach rechts auf, so dass die ausgeübte Geste als die Geste der ersten Art 3, 4, 31 identifiziert wird. Dementsprechend wird der Aktuator 9 zum Betätigen des Schalters 10 durch die Signalauswerteeinheit 7 angesteuert.

Ein Vefahren zum Identifizieren der letzten vier Arten von Gesten und zum Betreiben der Schalterbetätigungseinrichtung 11 weist die Schritte in Bezug auf Figuren 6 und 7 auf: Indem die nicht-taktile Geste mit der Hand 2 ausgeübt wird, werden von den Pixeln 21 bis 24 die Signalausschläge 78 ausgegeben. Die Signale 71 bis 74 werden untersucht nach dem Auftreten der Aufeinanderfolge der Signalausschläge 78 inklusive dem Warteniveau 77. Dann wird überprüft, ob die Signalausschläge 79 eine entgegengesetzte Richtung haben wie die Signalausschläge 80, und ob der Zeitversatz der Signalausschläge 79 innerhalb 50 ms liegt. Ferner wird überprüft, ob der Zeitversatz jeweils der zeitlich ersten beiden Signalausschläge 71, 74 und der beiden zeitlich letzten Signalausschläge 72, 73 innerhalb von 0,5 ms liegt. Liegt außerdem die Dauer der Wartephase 4 innerhalb 100 ms und 1500 ms und liegt der Zeitversatz des zeitlich ersten 71, 74 und des zeitlich letzten 72, 73 Signalausschlags 80 zwischen 10 ms und 100 ms, ist die Richtung der ausgeübten Geste während der Translationsphase als eine der vier anderen Richtungen identifizierbar. Gemäß Figuren 6 und 7 weist die ausgeübte Geste die Richtung von links oben nach rechts unten auf, so dass die ausgeübte Geste als die Geste der fünften Art 3, 4 , 35 identifiziert wird. Dementsprechend wird der Aktuator 9 zum Betätigen des Schalters 10 durch die Signalauswerteeinheit 7 angesteuert.

Alternativ ist für die Definition und Identifizierung der Arten von Gesten denkbar, dass die Dauer der Wartephase bei Null liegt, wobei der untere Warteschwellenwert und der obere Warteschwellenwert zusammenfallen und somit bei 0 ms liegen.

Ferner wird bei beiden Verfahren überprüft, ob der Betrag der ersten Ableitung nach der Zeit des steilsten Wendepunkts der Signalausschläge 49, 79 größer als der Betrag der ersten Ableitung nach der Zeit des steilsten Wendepunkts der Signalausschläge 50, 80 ist. Es wird außerdem überprüft, ob die Beträge der Extremwerte der Signalausschläge 49, 50, 79, 80 größer als ein vorherbestimmter Grenzwert sind, mit dem Störsignale der Pixel 21 bis 24 ausgeblendet werden. Schließlich wird überprüft, ob der Betrag des Warteniveaus 47, 77 höchstens bei 20% mindestens eins der Beträge der Extremwerte liegt und im Wesentlichen Null ist.

### Bezugszeichenliste

- 1: Gestensensor
- 2: Hand
- 3: Annäherungsphase
- 4: Wartephase
- 5: "Push"-Geste
- 6: Rhombus
- 7: Signalauswerteeinheit
- 8: Signalleitung
- 9: Aktuator
- 10: Schalter
- 11: Schalterbetätigungseinrichtung
- 21: erstes Pixel
- 22: zweites Pixel
- 23: drittes Pixel
- 24: viertes Pixel
- 25: Abstand von zwei benachbarten Pixel
- 26: Längsrichtung
- 27: Querrichtung
- 28: Längsdiagonale
- 29: Querdiagonale
- 31: Translationsgeste erster Art
- 32: Translationsgeste zweiter Art
- 33: Translationsgeste dritter Art
- 34: Translationsgeste vierter Art
- 35: Translationsgeste fünfter Art
- 36: Translationsgeste sechster Art
- 37: Translationsgeste siebter Art
- 38: Translationsgeste achter Art
- 41: Signal des ersten Pixels
- 42: Signal des zweiten Pixels
- 43: Signal des dritten Pixels
- 44: Signal des vierten Pixels
- 45: Abszisse
- 46: Ordinate
- 47: Warteniveau
- 48: Signalausschlag
- 49: Signalausschlag hervorgerufen in der Annäherungsphase
- 50: Signalausschlag hervorgerufen in der Translationsphase
- 51: erstes Minimum
- 52: zweites Minimum
- 53: drittes Minimum
- 54: viertes Minimum
- 61: erster Zeitpunkt
- 62: zweiter Zeitpunkt
- 63: dritter Zeitpunkt
- 64: Zeitversatz
- 71: Signal des ersten Pixels
- 72: Signal des zweiten Pixels
- 73: Signal des dritten Pixels
- 74: Signal des vierten Pixels
- 75: Abszisse
- 76: Ordinate
- 77: Signalniveau bei Pixelpassivität
- 78: Signalausschlag
- 79: erster Teil des Signalausschlags bei Annäherung
- 80: zweiter Teil des Signalausschlags bei Translationsgeste 31
- 81: erstes Minimum
- 82: zweites Minimum
- 83: drittes Minimum
- 84: viertes Minimum
- 91: erster Zeitpunkt
- 92: zweiter Zeitpunkt
- 94: Zeitversatz

## Patentansprüche

1. Schalterbetätigungseinrichtung (11) zum Betätigen eines Schalters (10) durch acht mögliche Arten (3, 4, 31 bis 38) von nicht-taktilen Gesten, die mit einem Wärme emittierenden Teil auszuüben sind, mit einem Gestensensor (1), der eingerichtet ist beim Ausüben einer der Arten (3, 4, 31 bis 38) der Gesten vom Teil emittierte Wärme mittels vier Pixel (21 bis 24) zu detektieren und pro Pixel (21 bis 24), die jeweils einen Dünnfilm aus pyroelektrischem Material aufweisen, ein Signal (41 bis 44, 71 bis 74) mit einem Signalausschlag (48, 78) entsprechend dem zeitlichen Intensitätsverlauf der vom Dünnfilm des entsprechenden Pixels (21 bis 24) detektierten Wärme auszugeben, einer Signalauswerteeinheit (7), mit der aus dem zeitlichen Aufeinanderfolgen der Signalausschläge (48, 78) die Ausübung einer der Arten der Gesten ermittelbar ist, und einem Aktuator (9), der von der Signalauswerteeinheit (7) angesteuert wird und, sobald die Ausübung einer der Arten der Gesten ermittelt ist, den Schalter (10) betätigt, wobei die Arten (3, 4, 31 bis 38) der Geste von einer Annäherungsphase (3), bei der das Teil sich dem Gestensensor (1) annähert, einer darauffolgenden Wartephase (4), bei der das Teil in der Nähe des Gestensensors (1) verharrt, und einer darauffolgenden Translationsphase, bei der das Teil in eine von acht Richtungen sich bewegt, gebildet ist, wobei vier erste Richtungen eine Längsrichtung (31), eine der Längsrichtung (31) entgegen gerichtete Richtung (32), eine Querrichtung (33), die im rechten Winkel zu der Längsrichtung (31) ist, eine der Querrichtung (33) entgegen gerichtete Richtung (34) sind und vier andere Richtungen (35 bis 38) jeweils um 45° zu einer der ihr entsprechenden vier ersten Richtungen (31 bis 34) gedreht sind, wobei die vier Pixel (21 bis 24) jeweils in einer der Ecken eines konvexen Vierecks angeordnet sind, dessen eine der Diagonalen (29) im Wesentlichen parallel zur Längsrichtung (31) und die andere Diagonale (28) im Wesentlichen parallel zur Querrichtung sind (33).

2. Schalterbetätigungseinrichtung (11) gemäß Anspruch 1, wobei das pyroelektrische Material Bleizirkonattitanat ist.

3. Schalterbetätigungseinrichtung (11) gemäß Anspruch 1 oder 2, wobei das Viereck ein Rhombus (6) ist.

4. Schalterbetätigungseinrichtung (11) gemäß einem der Ansprüche 1 bis 3, wobei der Abstand (25) von zwei unmittelbar benachbarten Pixeln (21 bis 24) zwischen 50 µm bis 300 µm liegt.

5. Schalterbetätigungseinrichtung (11) gemäß einem der Ansprüche 1 bis 4, wobei das Teil eine menschliche Hand (2) und die vom Teil emittierte Wärme die von der menschlichen Hand (2) abgestrahlte Körperwärme ist.

6. Mobiles Gerät mit der Schalterbetätigungseinrichtung (11) gemäß einem der Ansprüche 1 bis 5, wobei der Schalter (10) zum Aktivieren / Desaktivieren einer Funktionalität des mobilen Gerätes in diesem verschaltet ist.

7. Verfahren zum Betreiben einer Schalterbetätigungseinrichtung (11) gemäß einem der Ansprüche 1 bis 5, mit den Schritten:
- Ausgeben von den Pixeln (21 bis 24) der Signalausschläge (49, 79) hervorgerufen in der Annäherungsphase (3) und der Signalausschläge (50, 80) hervorgerufen in der Translationsphase an die Signalauswerteeinheit (7), indem die nicht-taktile Geste mit dem Wärme emittierenden Teil ausgeübt wird, wobei zwischen den Signalausschlägen (49, 79 bzw. 50, 80) während der Wartephase (4) vom Signal ein Warteniveau (47, 77) erreicht wird, das einen geringeren Betrag hat als die Beträge der Extremwerte der Signalausschläge (56, 57);
- Überwachen des Signals (41 bis 44, 71 bis 74) und Identifizieren des Auftretens einer Aufeinanderfolge der Signalausschläge (48, 78) und dem zeitlich dazwischen liegenden Warteniveau (47, 77) des Signals (41 bis 74, 71 bis 74); Sobald die Aufeinanderfolge identifiziert wurde, Fortfahren mit dem nächsten Schritt;
- Überprüfen, ob die Signalausschläge (49, 79) hervorgerufen in der Annäherungsphase (3) eine entgegengesetzte Richtung haben wie die Signalausschläge (50, 80) hervorgerufen in der Translationsphase; Ist die Überprüfung positiv, Fortfahren mit den nächsten Schritt;
- Überprüfen, ob der Zeitversatz der Signalausschläge (49, 79) hervorgerufen in der Annäherungsphase (3) innerhalb einer ersten vorherbestimmten Zeitspanne liegt; Ist die Überprüfung positiv, Fortfahren mit dem nächsten Schritt;
- Überprüfen, ob der Zeitversatz des zeitlich ersten (44, 71, 74) und des zeitlich letzten (42, 72, 73) Signalausschlags (50, 80) hervorgerufen in der Translationsphase innerhalb zweier Schwellenwerte liegt, deren unterer Schwellenwert größer als Null ist; Ist die Überprüfung positiv, Fortfahren mit dem nächsten Schritt;
- Identifizieren einer der acht Arten der Gesten (3, 4, 31 bis 38) anhand der zeitlichen Abfolge der Signalausschläge (50, 80) hervorgerufen in der Translationsphase;
- Je nach identifizierter Art der Geste (3, 4, 31 bis 38): Entsprechendes Ansteuern des Aktuators (9) zum Betätigen des Schalters (10) durch die Signalauswerteeinheit (7).

8. Verfahren gemäß Anspruch 7, wobei die erste vorherbestimmte Zeitspanne maximal 40 ms lang ist.

9. Verfahren gemäß Anspruch 7 oder 8, wobei der untere Schwellenwert bei 10 ms und der obere Schwellenwert bei 100 ms liegt.

10. Verfahren gemäß einem der Ansprüche 7 bis 9, mit dem Schritt:
- Überprüfen, ob der zeitliche Versatz derjenigen Signalausschläge (50, 00) hervorgerufen in der Translationsphase, die zeitlich zwischen dem ersten (44, 71, 74) und dem zeitlich letzten (42, 72, 73) Signalausschlag (50, 80) hervorgerufen in der Translationsphase innerhalb einer zweiten vorherbestimmten Zeitspanne, insbesondere ist die zweite vorherbestimmte Zeitspanne 0,5 ms, liegt, wodurch die Richtung der ausgeübten Geste während der Translationsphase als eine der vier ersten Richtungen identifizierbar wird; Ist die Überprüfung positiv, Fortfahren mit dem nächsten Schritt.

11. Verfahren gemäß einem der Ansprüche 7 bis 9, mit dem Schritt:
- Überprüfen, ob der zeitliche Versatz der zeitlich ersten beiden Signalausschläge (71, 74) und der letzten beiden Signalausschläge (72, 73) hervorgerufen in der Translationsphase innerhalb einer zweiten vorherbestimmten Zeitspanne, insbesondere ist die zweite vorherbestimmte Zeitspanne 0,5 ms, liegt, wodurch die Richtung der ausgeübten Geste während der Translationsphase als eine der vier anderen Richtungen identifizierbar wird; Ist die Überprüfung positiv, Fortfahren mit dem nächsten Schritt.

12. Verfahren gemäß einem der Ansprüche 7 bis 11, mit dem Schritt:
- Überprüfen, ob die Dauer der Wartephase (4) innerhalb zweier Warteschwellenwerte liegt, wobei deren unterer Warteschwellenwert größer als Null ist, wobei insbesondere der untere Warteschwellenwert bei 100 ms und der obere Warteschwellenwert bei 1500 ms liegt; Ist die Überprüfung positiv, Fortfahren mit dem nächsten Schritt.

13. Verfahren gemäß einem der Ansprüche 7 bis 12, mit dem Schritt:
- Überprüfen, ob der Betrag der ersten Ableitung nach der Zeit des steilsten Wendepunkts der Signalausschläge (49, 79) hervorgerufen in der Translationsphase größer als der Betrag der ersten Ableitung nach der Zeit des steilsten Wendepunkts der Signalausschläge (50, 80) hervorgerufen in der Annäherungsphase (3) ist; Ist dies der Fall, Fortfahren mit dem nächsten Schritt.

14. Verfahren gemäß einem der Ansprüche 7 bis 13, mit dem Schritt:
- Überprüfen, ob die Beträge der Extremwerte der Signalausschläge (49, 50, 79, 80) größer als ein vorherbestimmter Grenzwert sind; Ist dies der Fall, Fortfahren mit dem nächsten Schritt.

15. Verfahren gemäß einem der Ansprüche 7 bis 14, mit dem Schritt:
- Überprüfen, ob der Betrag des Warteniveaus (47, 77) höchstens bei 20% mindestens eins der Beträge der Extremwerte ist; Ist dies der Fall, Fortfahren mit dem nächsten Schritt.

16. Verfahren gemäß einem der Ansprüche 7 bis 15, mit dem Schritt:
- Überprüfen, ob das Warteniveau (47, 77) im Wesentlichen bei Null liegt.

## Claims

1. Switch actuating device (11) for actuating a switch (10) by eight possible types (3, 4, 31 to 38) of non-tactile gestures, which are to be carried out with a heat-emitting part, with a gesture sensor (1), which, at the exercising of one of the types (3, 4, 31 to 38) of the gestures, is configured so as to detect the heat emitted by the part by means of four pixels (21 to 24), and to issue per pixel (21 t24), which in each case comprise a thin film of pyroelectrical material, a signal (41 to 44, 71 to 74), with a signal amplitude (48, 78) corresponding to the temporal intensity course of the heat detected from the thin film of the corresponding pixel (21 to 24), with a signal evaluation unit (7), with which, from the temporal sequences of the signal amplitudes (48, 78), the exercise of one of the types of gestures can be determined, and with an actuator (9), which is in turn actuated by the signal evaluation unit (7), and, as soon as the exercise of one of the types of gestures is determined, actuates the switch (10), wherein the type (3, 4, 31 to 39) of gesture is formed from an approach phase (3), in which the part approaches the gesture sensor (1), followed by a waiting phase (4), in which the part remains stationary in proximity to the gesture sensor (1), and a translation phase following this, in which the part moves into one of eight directions, wherein four first directions are a longitudinal direction (31), a direction (32) aligned contrary to the longitudinal direction (31), a transverse direction (33), which is at right angles to the longitudinal direction (31), a direction (34) aligned contrary to the transverse direction (34), and four other directions (35 to 38), which in each case are rotated by 45° to the one of the four first directions (31 to 34) which corresponds to the particular other direction, wherein the four pixels (21 to 24) are in each case arranged in one of the corners of a convex rectangle, of which one of the diagonals (29) is essentially parallel to the longitudinal direction (31) and the other diagonal (28) is essentially parallel to the transverse direction (33).

2. Switch actuating device (11) according to claim 1, wherein the pyroelectrical material is lead zirkonate titanate.

3. Switch actuating device (11) according to claim 1 or 2, wherein the rectangle is a rhombus (6).

4. Switch actuating device (11) according to any one of claims 1 to 3, wherein the distance interval between two immediately adjacent pixels (21 to 24) lies between 50 µm to 300 µm.

5. Switch actuating device (11) according to any one of claims 1 to 4, wherein the part is a human hand (2) and the heat emitted by the part is the bodily warmth radiated by the human hand (2).

6. Mobile device with the switch actuating device (11) according to any one of claims 1 to 5, wherein the switch (10) for activating/deactivating a function performance of the mobile device is part of the circuitry in this device.

7. Method for operating a switch actuating device (11) according to any one of claims 1 to 5, with the steps:
- Outputting of the pixels (21 to 24) of the signal amplitudes (49, 79) incurred in the approach phase (3), and of the signal amplitudes (50, 80) incurred in the translation phase, to the signal evaluation unit (7), in that the non-tactile gesture is exercised with the part emitting heat, wherein, between the signal amplitudes (49, 79, and 50, 80 respectively) during the waiting phase (4) of the signal, a waiting level (47, 77) is reached, which has a lower amount than the amounts of the extreme values of the signal amplitudes (56, 5);
- Monitoring of the signal (41 to 44, 71 to 74) and identifying of the occurrence of a sequence of signal amplitudes (48, 78) and the temporal waiting level (47, 77) of the signal (41 to 74, 71 to 74) present between them; as soon as the sequence is identified, continuation with the next step;
- Checking whether the signal amplitudes (49, 79) incurred in the approach phase (3) have an opposed direction like the signal amplitudes (50, 80) incurred in the translation phase; if the check is positive, continue with the next step;
- Checking whether the time offset of the signal amplitudes (49, 79) incurred in the approach phase (3) lies within a predetermined time span; if the check is positive, continue with the next step;
- Checking whether the time offset of the temporally first signal amplitude (44, 71, 74) and the temporally last signal amplitude (42, 72, 73) incurred in the translation phase lies within two threshold values, of which the lower threshold value is greater than zero; if the check is positive, continue with the next step;
- Identifying one of the eight types of gestures (3, 4, 31 to 38) on the basis of the temporal sequence of the signal amplitudes (50, 80) incurred in the translation phase;
- Depending on the type of gesture identified (3, 4, 31 to 38): Corresponding actuation of the actuator (9) to actuate the switch (10) by the signal evaluation unit (7).

8. Method according to claim 7, wherein the first predetermined time span is a maximum of 40 ms long.

9. Method according to claim 7 or 8, wherein the lower threshold value lies at 10 ms and the upper threshold value lies at 100 ms.

10. Method according to any one of claims 7 to 9, with the step:
- Checking whether the temporal offset of those signal amplitudes (50, 80) incurred in the translation phase, which temporally lies between the first (44, 71, 74) and the temporally last (42, 72, 73) signal amplitude (50, 80) incurred in the translation phase, lies within a second predetermined time span, in particular whether the second predetermined time span is 0.5 ms, as a result of which the direction of the gestures exercised during the translation phase can be identified as one of the four first directions; if the check is positive, continue with the next step.

11. Method according to any one of claims 7 to 9, with the step:
- Checking whether the temporal offset of the temporally first two signal amplitudes (71, 74) and the last two signal amplitudes (72, 73) incurred in the translation phase lies within a second predetermined time span, in particular whether the second predetermined time span is 0.5 ms, as a result of which the direction of the gesture exercised during the translation phase can be identified as one of the four other directions; if the check is positive, continue with the next step.

12. Method according to any one of claims 7 to 11, with the step:
- Checking whether the duration of the waiting phase (4) lies between two waiting threshold values, wherein their lower waiting threshold value is greater than zero, wherein, in particular, the lower waiting threshold value lies at about 100 ms and the upper waiting threshold value lies at about 1500 ms; if the check is positive, continue with the next step.

13. Method according to any one of claims 7 to 12, with the step:
Checking whether the amount of the first derivation after the time of the steepest turning point of the signal amplitudes (49, 79) incurred in the translation phase is greater than the amount of the first derivation after the time of the steepest turning point of the signal amplitudes (50, 80) incurred in the approach phase (3); if this is the case, continue with the next step.

14. Method according to any one of claims 7 to 13, with the step:
- Checking whether the amounts of the extreme values of the signal amplitudes (49, 50, 79, 80) are greater than a predetermined limit value; if this is the case, continue with the next step.

15. Method according to any one of claims 7 to 14, with the step:
- Checking whether the amount of the waiting level (47, 77) is at the most at 20% of at least one of the amounts of the extreme values; if this is the case, continue with the next step.

16. Method according to any one of claims 7 to 15, with the step:
- Checking whether the waiting level (47, 77) lies essentially at zero.

## Revendications

1. Dispositif d'actionnement de commutateur (11) pour l'actionnement d'un commutateur (10) de huit types différents (3, 4, 31 à 38) de gestes non tactiles, qui doivent être réalisés avec une partie émettant de la chaleur, avec un capteur de gestes (1), qui est conçu pour détecter, lors de la réalisation d'un des types (3, 4, 31 à 38) de gestes, la chaleur émise par la partie, au moyen de quatre pixels (21 à 24) et pour générer, pour chaque pixel (21 à 24), qui comprennent chacun un film mince en matériau pyro-électrique, un signal (41 à 44, 71 à 74) avec une amplitude de signal (48, 78) correspondant au tracé d'intensité en fonction du temps de la chaleur détectée par le film mince du pixel (21 à 24) correspondant, une unité d'analyse de signaux (7) avec laquelle, à partir de la succession temporelle des amplitudes de signaux (48, 78), la réalisation d'un des types de gestes peut être déterminée, et un actionneur (9) qui est contrôlé par l'unité d'analyse de signaux (7) et, dès que la réalisation d'un des types de gestes est déterminée, le commutateur (10) est détecté, les types (3, 4, 31 à 38) de gestes étant constitués d'une phase d'approche (3), lors de laquelle la partie s'approche du capteur de gestes (1), d'une phase d'attente (4) suivante, lors de laquelle la partie demeure à proximité du capteur de gestes (1), et d'une phase de translation suivante, lors de laquelle la partie se déplace dans une parmi huit directions, quatre premières directions étant une direction longitudinale (31), une direction (32) opposée à la direction longitudinale (31), une direction transversale (33), qui est perpendiculaire à la direction longitudinale (31), une direction (34) opposée à la direction transversale (33) et quatre autres directions (35 à 38) étant tournées chacune à 45° par rapport à une des quatre premières directions (31 à 34) correspondantes, les quatre pixels (21 à 24) étant disposés chacun dans un des angles d'un quadrilatère convexe dont une des diagonales (29) est globalement parallèle à la direction longitudinale (31) et l'autre diagonale (28) est globalement parallèle à la direction transversale (33).

2. Dispositif d'actionnement de commutateur (11) selon la revendication 1, le matériau pyro-électrique étant du titanate de plomb-zircon.

3. Dispositif d'actionnement de commutateur (11) selon la revendication 1 ou 2, le quadrilatère étant un losange (6).

4. Dispositif d'actionnement de commutateur (11) selon l'une des revendications 1 à 3, la distance (25) entre deux pixels (21 à 24) immédiatement adjacents est de 50 µm à 300 µm.

5. Dispositif d'actionnement de commutateur (11) selon l'une des revendications 1 à 4, la partie étant une main humaine (2) et la chaleur émise par la partie étant la chaleur corporelle émise par la main humaine (2).

6. Appareil mobile avec le dispositif d'actionnement de commutateur (11) selon l'une des revendications 1 à 5, le commutateur (10) étant interconnecté dans d'appareil mobile pour l'activation/désactivation d'une fonctionnalité de celui-ci.

7. Procédé d'exploitation d'un dispositif d'actionnement de commutateur (11) selon l'une des revendications 1 à 5, avec les étapes suivantes :
- envoi par les pixels (21 à 24) des amplitudes de signaux (49, 79) provoquées dans la phase d'approche (3) et des amplitudes de signaux (50, 80) provoquées dans la phase de translation à l'unité d'analyse de signaux (7), grâce au fait que les gestes non tactiles sont réalisés avec la partie émettant de la chaleur, moyennant quoi, entre les amplitudes de signaux (49, 79 resp. 50, 80), pendant la phase d'attente (4), un niveau d'attente (47, 77) est atteint par le signal, qui présente une valeur plus faible que les valeurs extrêmes des amplitudes de signaux (56, 57) ;
- surveillance du signal (41 à 44, 71 à 74) et identification de l'apparition d'une succession d'amplitudes de signaux (48, 78) et du niveau d'attente (47, 77), situé temporellement entre elles, du signal (41 à 74, 71 à 74) ; dès que la succession a été identifiée, continuation avec l'étape suivante ;
- vérification si les amplitudes de signaux (49, 79) provoqués dans la phase d'approche (3) présente une direction opposée aux amplitudes de signaux (50, 80) provoquées dans la phase de translation ; si la vérification est positive, continuation avec l'étape suivante ;
- vérification si le décalage temporel des amplitudes de signaux (49, 79) provoquées dans la phase d'approche (3) se trouve dans une première période prédéterminée ; si la vérification est positive, continuation avec l'étape suivante ;
- vérification le décalage temporel de la première (44, 71, 74) et de la dernière (42, 72, 73) amplitude de signal (50, 80) provoquée dans la phase de translation se trouve entre deux valeurs seuil, la valeur seuil inférieure étant supérieure à zéro ; si la vérification est positive, continuation avec l'étape suivante ;
- identification d'un des huit types de gestes (3, 4, 31 à 38) à l'aide de la suite temporelle des amplitudes de signaux (50, 80) provoquées dans la phase de translation ;
- selon le type identifié de geste (3, 4, 31 à 38) : contrôle correspondant de l'actionneur (9) pour l'actionnement du commutateur (10) par l'unité d'analyse de signaux (7).

8. Procédé selon la revendication 7, la première période prédéterminée étant de 40 ms maximum.

9. Procédé selon la revendication 7 ou 8, la valeur seuil inférieure étant de 10 ms et la valeur seuil supérieure étant de 100 ms.

10. Procédé selon l'une des revendications 7 à 9, avec l'étape suivante :
- vérification si le décalage temporel des amplitudes de signaux (50, 80) provoquées dans la phase de translation, l'amplitude de signal (50, 80) temporellement entre la première (44, 71, 74) et la dernière (42, 72, 73) provoquée dans la phase de translation, plus particulièrement si la deuxième période prédéterminée est de 0,5 ms, se trouve dans une deuxième période prédéterminée, ce qui permet d'identifier la direction des gestes réalisés pendant la phase de translation comme un des quatre premières directions ; si la vérification est positive, continuation avec l'étape suivante.

11. Procédé selon l'une des revendications 7 à 9, avec l'étape suivante :
- vérification si le décalage temporel des deux premières amplitudes de signaux (71, 74) et des deux dernières amplitudes de signaux (72, 73) provoquées dans la phase de translation, plus particulièrement su la deuxième période, prédéterminée est de 0,5 ms, se trouve dans une deuxième période prédéterminée, ce qui permet d'identifier la direction des gestes réalisés pendant la phase de translation comme un des quatre autres directions ; si la vérification est positive, continuation avec l'étape suivante.

12. Procédé selon l'une des revendications 7 à 11, avec l'étape suivante :
- vérification si la durée de la phase d'attente (4) se trouve entre deux valeurs seuils d'attente, la valeur seuil d'attente inférieure étant supérieure à zéro, plus particulièrement la valeur seuil d'attente inférieure étant de 100 ms et la valeur seuil d'attente supérieure étant de 1500 ms ; si la vérification est positive, continuation avec l'étape suivante.

13. Procédé selon l'une des revendications 7 à 12, avec l'étape suivante :
- vérification si la valeur de la première dérivée en fonction du temps du point d'inflexion le plus pentu des amplitudes de signaux (49, 79) provoquées dans la phase de translation est supérieure à la valeur de la première dérivée en fonction du temps du point d'inflexion des amplitudes de signaux (50, 80) provoquées dans la phase d'approche (3) ; si c'est le cas, continuation avec l'étape suivante.

14. Procédé selon l'une des revendications 7 à 13, avec l'étape suivante :
- vérification si les valeurs extrêmes des amplitudes de signaux (49, 50, 79, 80) sont supérieures à une valeur limite prédéterminée ; si c'est le cas, continuation avec l'étape suivante.

15. Procédé selon l'une des revendications 7 à 14, avec l'étape suivante :
- vérification si la valeur du niveau d'attente (47, 77) est égale à 20 % maximum d'au moins une des valeurs extrêmes ; si c'est le cas, continuation avec l'étape suivante.

16. Procédé selon l'une des revendications 7 à 15, avec l'étape suivante :
- vérification si le niveau d'attente (47, 77) est globalement égal à zéro.
